(19) Europäisches Patentamt
European Patent Office
Office européen des brevets

(11) **EP 4 278 154 B1**

(12) **FASCICULE DE BREVET EUROPEEN**

(45) Date de publication et mention de la délivrance du brevet:
**28.08.2024   Bulletin 2024/35**

(21) Numéro de dépôt: **22705071.3**

(22) Date de dépôt: **06.01.2022**

(51) Classification Internationale des Brevets (IPC):
***G01D 5/14*** *(2006.01)*

(52) Classification Coopérative des Brevets (CPC):
**G01D 5/145**

(86) Numéro de dépôt international:
**PCT/FR2022/050028**

(87) Numéro de publication internationale:
**WO 2022/152996 (21.07.2022 Gazette 2022/29)**

(54) **CAPTEUR DE POSITION SANS CONTACT COMPORTANT UN AIMANT PERMANENT**

KONTAKTLOSER POSITIONSSENSOR MIT EINEM PERMANENTMAGNET

CONTACTLESS POSITION SENSOR INCLUDING A PERMANENT MAGNET

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.01.2021   FR 2100365**

(43) Date de publication de la demande:
**22.11.2023   Bulletin 2023/47**

(73) Titulaire: **Absolute Magnetics AG**
**9055 Bühler (CH)**

(72) Inventeur: **ARLOT, Richard**
**70700 Bonnevent-Velloreille (FR)**

(74) Mandataire: **IP Trust**
**2, rue de Clichy**
**75009 Paris (FR)**

(56) Documents cités:
**FR-A1- 2 898 189     FR-A1- 2 923 903**
**FR-A1- 2 937 722     FR-A1- 2 965 347**

**Description**

**Domaine de l'invention**

La présente invention concerne le domaine de capteurs de position sans contact, magnétique et/ou électromagnétique pour la mesure précise d'une position absolue angulaire ou linéaire. De tels capteurs permettent de détecter une position angulaire ou un déplacement linéaire avec une grande précision de l'ordre de 0,1% de la course totale, soit < 0.5° pour une détection réalisée sur un tour complet.

On connaît dans l'état de la technique, des dispositifs de mesure magnétique de position angulaire (ou linéaire) d'un point de référence, mobile angulairement autour d'un axe (ou linéairement), par rapport à un point fixe. Un tel dispositif de mesure comprend habituellement un élément magnétique (ou élément magnéto-coercitif - EMC) en rotation et un élément magnéto-sensible (EMS) mesurant le flux magnétique ou les composantes axiales et/ou radiales de ce flux (ou champ) magnétique, pour en déduire par calcul la position angulaire de l'élément magnétique sensible par rapport à un point de référence.

Une première solution de capteur de type «capteur à effet Hall 360°» ou encore «capteur à effet Hall capteur sinus-cosinus» utilise une seule sonde mesurant au moins deux composantes du champ magnétique, ou utilise un circuit magnétique générant une variation proportionnelle de flux durant l'excursion. La précision de tels dispositifs de mesure est limitée (typiquement $\geq 1°$ mécanique) et peut être considérée comme insuffisante pour certaines applications (pour la robotique par exemple).

Le même type de capteur utilisant au moins deux sondes à effet Hall permet d'améliorer la précision de tels dispositifs de mesure, notamment par la composition de différentes composantes de champ, mais reste encore proche de 0.5° degré mécanique et peut encore être considérée comme insuffisante pour certaines applications (machine-outil par exemple).

Une autre famille de capteurs de type ferromagnétique et avec un stator bobiné, communément appelé résolveur (résolveur reluctant par exemple), utilise un système de bobines magnétique émettrice et réceptrices réparties sur la partie statorique. La précision de ces résolveurs est très importante mais ces capteurs sont décrits comme encombrants, chers et compliqués à assembler sur l'application. Ils sont largement utilisés dans l'industrie (machine-outil par exemple) et dans l'automobile (direction assistée, transmission) mais restent limités à quelques applications haut de gamme.

Une troisième famille de capteurs exploitent plusieurs pistes magnétiques (chacune portant donc un profil d'aimantation ou de flux magnétique donné), généralement indexés entre elles.

Les capteurs de type « Nonius » ou encore « à effet Vernier » pour lesquels le nombre de paires de pôles sur les 2 pistes est différents, générant un déphasage des signaux magnétiques utilisés pour préciser la position angulaire (ou linéaire), font partie de cette troisième famille.

On connaît aussi dans cette famille les capteurs de type « encoder » multipolaire permettant de créer des signaux digitaux qui combinés permettent de déterminer une position angulaire relative ou absolue, ou encore les capteurs combinés associant un « capteur à effet Hall 360° » et un capteur digital de type « encoder », permettant de combiner mesure analogique grossière sur un tour complet et une multitude de signaux digitaux permettant d'affiner cette mesure localement via un algorithme dédié permettant le calcul d'un valeur angulaire précise.

Ces capteurs (ou encodeurs) sont très précis (<0.5°) et plus compact que les résolveurs, mais ils nécessitent l'utilisation d'au moins 2 pistes magnétiques (ou EMC) et, de au moins une sonde magnétique (ou encore EMS) par piste. Ces capteurs sont décrits comme plus chers et compliqués à assembler que des capteurs ne comportant qu'un unique EMC. Leur utilisation est généralement limitée aux technologies de positionnement de haute précision que l'on retrouve dans les satellites, les machines-outils, les robots d'assemblage, les robots médicaux.

**Etat de la technique**

On connaît en particulier dans l'état de la technique le brevet français FR2965347 décrivant un procédé pour paramétrer un système de mesure de position absolue comportant un aimant permanent, au moins une sonde en mouvement relatif par rapport audit aimant sur une course donnée, et des moyens de calcul fournissant une information de position calculée en fonction de l'arctangente du rapport, affecté d'un coefficient de correction G, entre les signaux de sortie de la sonde, ces signaux étant pseudo-sinusoïdaux et en quadrature. Ce procédé comprend une opération d'optimisation consistant à choisir la valeur du coefficient G qui minimise les erreurs du système de mesure dues au caractère pseudo-sinusoïdal des signaux de sortie de la sonde.

On connaît aussi le brevet français FR2923903 décrivant un capteur de position magnétique angulaire ou linéaire comportant un élément mobile constitué d'au moins un aimant présentant une direction d'aimantation qui varie linéairement suivant la direction de déplacement de l'aimant dans une surface définie par ladite direction de déplacement et une direction normale, au moins quatre éléments magnétosensibles et au moins un circuit de traitement délivrant un signal fonction de la position absolue de l'élément mobile dans lequel un premier jeu d'éléments magnétosensibles est composé d'un couple d'éléments magnétosensibles localisés au même point, spatialement décalé d'un deuxième jeu d'éléments magnétosensibles), également composé d'un couple d'éléments magnétosensibles localisés au même point, suivant la direction de déplacement de l'aimant. Un élément magnétosensible du premier et du second jeu d'éléments magnétosensibles est apte à mesurer la composante tangentielle du champ magnétique et un élément magnétosensible du premier et du second jeu d'éléments magnétosensibles est apte à mesurer la composante normale du champ magnétique. Le circuit de traitement est apte à réaliser au moins deux combinaisons algébriques, chaque combinaison algébrique comprenant une composante du premier jeu d'éléments magnétosensibles et une composante du second jeu d'éléments magnétosensibles, de sorte à définir deux signaux sinusoïdaux sensiblement déphasés électriquement de 90°.

On connaît aussi le brevet FR2919385 décrivant une solution mettant en oeuvre deux capteurs 360° sans contact pour réaliser un capteur multitour absolu. Le premier capteur sans contact est utilisé pour mesurer l'angle de rotation de l'organe rotatif de 0 à 360° et le second capteur est utilisé pour déterminer le nombre de rotations complètes de l'organe rotatif. Un système mécanique de réduction continue de rapport n est intégré entre les deux capteurs. L'arbre d'entrée du réducteur est lié au premier capteur et le rotor du second capteur est lié à l'arbre de sortie du réducteur. Chaque fois que le premier capteur fait un tour complet, le deuxième capteur fait seulement 1/n tour. Le deuxième capteur permet d'obtenir une mesure de l'angle absolu total avec une précision et une résolution limitée mais le premier capteur résout ce problème en permettant d'affiner la mesure du deuxième capteur et ainsi obtenir une précision et une résolution très fines sur 360°. De plus, en cas de défaut du premier capteur le second permet quand même de détecter (résolution réduite n fois) la position dans le tour de l'organe rotatif et de détecter le disfonctionnement du premier capteur.

Le brevet FR2898189 décrit une autre solution de capteur magnétique de déplacement rotatif, linéaire ou curviligne utilisant au moins un aimant permanent et au moins un élément magnétosensible, mobiles l'un par rapport à l'autre, caractérisé en ce que l'aimant présente une direction d'aimantation qui varie sensiblement linéairement suivant la direction de déplacement de l'aimant sur une surface définie par ladite direction de déplacement et une direction normale, à l'exclusion d'une aimantation diamétrale dans le cas d'un capteur rotatif.

Le brevet EP2711663 décrit une autre solution sous la forme d'un disque, portant un point (P) mobile en rotation autour d'un axe (Z). Un premier capteur coopère avec un premier élément magnétique solidaire du disque pour mesurer une position angulaire approximative ($\Theta a$) du point (P) par rapport à une origine (O). Des seconds éléments magnétiques sont agencés circonférentiellement sur la périphérie du disque. Un second capteur est disposé à l'origine (O) pour mesurer, pour un second élément magnétique situé en regard de ce second capteur, la position angulaire d'une extrémité amont de ce second élément magnétique par rapport à l'origine (O). Des moyens déterminent quel second élément se situe en regard du second capteur, en fonction de la position angulaire approximative ($\theta a$). Des moyens calculent une position angulaire précise ($\theta$) du point de référence (P), en fonction du second élément déterminé et de la valeur mesurée par le second capteur.

## Inconvénients de l'art antérieur

Les capteurs magnétiques de l'état de la technique les plus simples ne permettent pas d'obtenir des précisions angulaires (ou linéaires) suffisantes pour être utilisé avec succès dans des applications demandant un positionnement de haute précision.

## Solution apportée par l'invention

La présente invention a pour but de remédier à cet inconvénient majeur, en fournissant un dispositif simple et peu coûteux de mesure magnétique d'une position angulaire ou linéaire. L'invention concerne selon son acception la plus générale un capteur de position sans contact comportant un aimant permanent (ou élément magnéto-coercitif) générant un champ magnétique et au moins un élément de détection du champs magnétique (ou élément magnéto-sensible) selon au moins deux directions, l'aimant permanent étant apte à se mouvoir selon une direction de déplacement et présentant une aimantation continûment variable suivant la direction de déplacement, caractérisé en ce que ladite variation de l'aimantation présente selon les différentes composantes de champ une forme correspondant à une combinaison d'au moins deux contributions (quasi-)périodiques, le capteur comportant en outre un calculateur pour combiner les valeurs de ces composantes de champ et pour déterminer une valeur de la position précise.

On entend par «quasi-périodique » la généralisation d'une combinatoire périodique, avec des motifs qui présentent des variations mineures d'une période à l'autre, mais des intervalles constants pour chacun des motifs.

L'élément de détection peut optionnellement être placé dans un concentrateur de flux.

Selon l'invention, ladite aimantation varie avantageusement selon les différentes composantes de champ selon une forme correspondant à une combinaison d'au moins deux contributions périodiques selon des périodes p et n*p différentes (n réel >0, constant ou variable sur le déplacement), le second motif étant le signal porteur du premier, ce double motif permettant de combiner une mesure grossière et une mesure fine de la position dans l'excursion réalisée via la mesure d'au moins deux des composantes du champ magnétique.

Avantageusement les signaux porteurs et portés sont indexés entre eux pour créer un déphasage proportionnel à l'excursion effectuée.

Selon un mode de réalisation particulier, lesdits signaux porteurs et portés sont apériodiques.

De préférence, l'aimantation présente au moins une anomalie magnétique pour la détection du tour complet mécanique ou une position donnée dans une excursion.

Selon une variante, ladite variation d'aimantation présente une forme correspondant à la combinaison de trois variations périodiques, le troisième motif de période m*p (m réel >0, constant ou variable sur le déplacement) permettant de réaliser par exemple une détection du nombre de tours complets mécaniques ou une ou plusieurs positions données dans une excursion.

Selon une variante, ledit aimant permanent (ou élément magnéto-coercitif) est constitué d'au moins un aimant permanent multipolaire, ou d'un assemblage d'aimant multipolaires.

Selon une variante, ledit aimant permanent est tout ou partie du rotor d'un moteur électrique, d'un générateur, d'un actionneur, d'un réducteur, d'un coupleur.

Avantageusement, ledit aimant permanent est constitué par un ensemble de boucles de courant.

Selon une variante, ladite variation d'aimantation présente une forme correspondant à la combinaison d'une multitude de variations périodiques ou quasi-périodiques, permettant de réaliser une détection précise de la position dans une excursion, de connaître le nombre d'excursions réalisées et de renforcer la précision de la mesure et sa résilience aux perturbations externes (champ magnétique parasite par exemple).

Avantageusement, ledit élément magnétosensible est constitué d'au moins une sonde Hall mesurant les au moins deux directions composantes de champ magnétique, ou d'un assemblage quasi-ponctuel d'éléments magnétos-sensibles.

Selon une alternative, ledit élément magnétosensible est constitué par une sonde magnétorésistive.

Selon une autre alternative, ledit élément magnétosensible est une sonde à courant de Foucault.

Selon une autre alternative, ledit élément magnétosensible comprend une pluralité de sondes.

Selon un mode de réalisation particulier, le capteur comporte en outre des moyens de calcul et de stockage des valeurs angulaires calculées et/ou de la linéarité du capteur.

Selon un mode de réalisation particulier, le dispositif de mesure selon l'invention combine détection analogique et une détection digital des composantes de champ magnétique, pour permettre par exemple de gagner en temps de calcul de la position.

Optionnellement, le dispositif présente un mode de fonctionnement (combinaison des composantes de champ) dégradé en cas de défaillance d'une des composantes du champ ou un mode de fonctionnement (combinaison des composantes de champ) permettant de compenser les perturbations de mesure d'origine externes.

L'invention concerne aussi un dispositif de mesure comportant des moyens de calcul, de stockage des valeurs angulaires calculées et/ou de la linéarité du capteur.

L'invention concerne aussi l'application d'un capteur de position susvisé pour la mesure de valeurs additionnelles sur un système complexe, comprenant une force, un couple, une accélération, un freinage, un déphasage, une vitesse d'ensemble, une direction de déplacement, un nombre de tour, une inertie, un balourd, une vibration, un bruit, un contenu harmonique, une température, une pression, un courant électrique, une tension électrique.

## Description détaillée d'un exemple non limitatif de réalisation

La présente invention sera mieux comprise à la lecture de la description qui suit, concernant un exemple non limitatif de réalisation illustré par les dessins annexés où :

[FIG. 1] la figure 1 représente une vue schématique d'un capteur de position angulaire selon l'invention

[FIG. 2] la figure 2 représente un premier exemple de profil d'aimantation selon l'invention

[FIG. 3] la figure 3 représente la courbe de variation des composantes de champ magnétique mesurées par la sonde de mesure

[FIG. 4] la figure 4 représente la courbe de variation des composantes de champ magnétique mesurées par la sonde de mesure ainsi que la moyenne du signal enveloppe

[FIG. 5] la figure 5 représente la courbe de variation des composantes de signal fin comportant P incréments, déphasés d'un quart de période p

[FIG. 6] la figure 6 représente la courbe de variation du signal Brad et du signal Btan, et un exemple de combinaison de ces signaux pour la détermination "grossière" de la valeur angulaire (atan) sur l'excursion.

[FIG. 7] la figure 7 représente la courbe de variation des signaux à P incréments issus des composantes Bz et Btan, et un exemple de combinaison de ces signaux pour la détermination "fine" de la valeur angulaire (atan) sur l'excursion.

[FIG. 8] la figure 8 représente un second exemple de profil d'aimantation selon l'invention et la description de la mesure de position indiquée par le ligne rouge [FIG. 9] la figure 9 représente un troisième exemple de profil d'aimantation selon l'invention ajusté tel que N'=2, P' =32 et T'=0

[FIG. 10] la figure 10 représente un quatrième exemple de profil d'aimantation selon l'invention ajusté tel que N"=2, P" =82 et T"=0

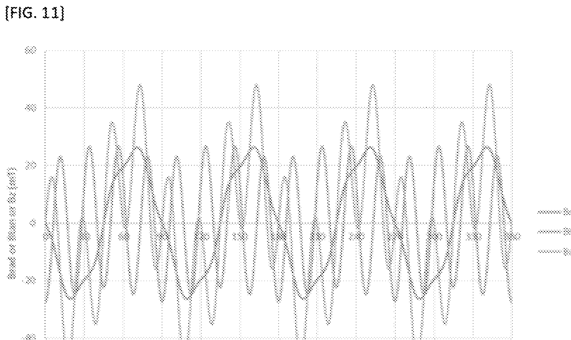

[FIG. 11] la figure 11 représente un cinquième exemple de profil d'aimantation selon l'invention ajusté tel que N=8, P=32 et T=0

[FIG. 12] la figure 12 représente le principe de détection adapté à un déplacement curviligne

[FIG. 13] la figure 13 représente le principe de détection adapté à un déplacement linéaire

## Structure mécanique d'un exemple de capteur angulaire selon l'invention

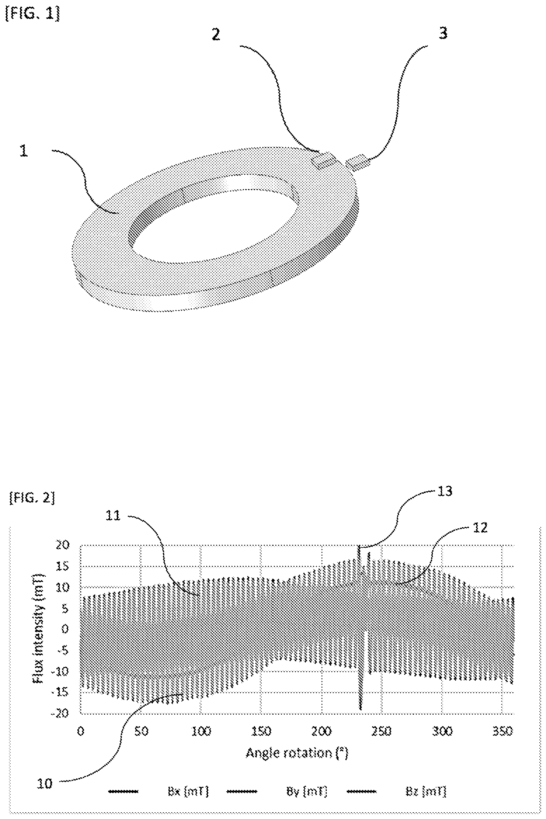

La figure 1 représente une structure de capteur rotatif selon l'invention. Le flux magnétique généré par un aimant (1) permanent de forme discale est collecté en périphérie de celui-ci par un ou deux éléments de détection situés radialement ou axialement (2, 3) mesurent deux composantes de l'induction magnétique suivant deux axes orthogonaux, au besoin par l'intermédiaire de collecteurs de flux définissant un entrefer dans lequel est placé l'élément de détection (2, 3), typiquement une sonde de Hall. Dans l'état de l'art, l'aimantation est dans certains cas variable diamétralement, et dans d'autres cas variable radialement et/ou axialement.

Il connu que chaque aimant permanent présente une aimantation dont la direction est définie par un vecteur d'aimantation. Ce vecteur d'aimantation définit la direction du champ magnétique à l'intérieur de l'aimant. Cette direction dépend de la façon dont l'aimant est polarisé lors de sa réalisation. Par exemple, un aimant non polarisé en forme de « bague » placé dans un champ magnétique unidirectionnel homogène suffisant aura sa direction d'aimantation orientée selon la direction de ce champ magnétique. Dans le cas où le champ magnétique est orienté suivant une direction perpendiculaire à l'axe de rotation de l'aimant (on parle alors d'une aimantation de type diamétrale) et si cet aimant se déplace en rotation autour de son axe, la direction d'aimantation vu en un point fixe de l'espace à l'intérieur de l'aimant va donc être continûment variable suivant une fonction linéaire. L'invention concerne la famille des capteurs où la direction d'aimantation de l'aimant permanent varie de façon multi-(quasi-)périodique. C'est le cas lorsque la direction d'aimantation reprend la même valeur lorsque l'aimant se déplace d'une distance prédéterminée (une période du signal selon l'une des composantes de champ).

## Principes généraux de l'invention

Les capteurs selon l'invention se différentient par le profil d'aimantation complexe se traduisant par des variations multi-périodiques de l'amplitude de l'aimantation (ou de son orientation par rapport à un axe ou point de référence) en fonction de la trajectoire relative de l'entrefer de mesure et de l'aimant, comme illustré selon un exemple non limitatif sur la figure 2, concernant un seul et même aimant annulaire, discal, tubulaire ou annulaire, et mesuré en un seul point de mesure. Dans cet exemple, Bx = Brad (courbe 10); By = Btan (courbe 11) ; Bz (courbe 12) ; pour ce profil le nombre d'incréments du signal selon les différentes axes de mesures N=2 ; P =216 et T =4 (N étant le nombre d'incréments définis sur le signal porteur, P et T les nombres d'incréments définis sur les signaux portés).

Le niveau d'aimantation est mesuré en un seul point par un ou plusieurs éléments magnéto-sensibles localisés sensiblement au même point, par exemple par une sonde de Hall de type Triaxis (nom commercial), et permettant le calcul d'une position angulaire (ou linéaire) avec une grande précision (<0.5° pour une détection réalisée sur un tour complet), peu encombrants et faciles à assembler.

Le profil d'aimantation présente selon un exemple un motif (porté) de période p comportant P incréments de mesure et un motif (porteur) de période p*n (n réel >0 ; constant ou variable) comportant N incréments. Ce double motif permet de combiner une détection grossière (sortie grossière) et une détection plus fine de la position absolue (sortie fine). Un incrément de mesure est par exemple constitué par la mesure d'un pôle magnétique. Deux pôles de polarité inverse pourront ainsi constituer un motif de période donnée.

La figure 2 illustre ces deux motifs évoqués précédemment et permettant les deux types de calcul de position :

- la sortie « grossière » permettant une lecture d'ensemble de la position sur un tour ; ce signal de sortie comporte un nombre prédéterminé de N incréments de mesure répartis sur l'intervalle de la mesure (1 tour mécanique par exemple) ; dans ce cas précis les composantes [Brad ; Btan] ou [Bz ; Btan] pourront être utilisés pour le calcul de la valeur angulaire, via le calcul de l'arc-tangente du ratio de ces composantes.
- une sortie « fine », porté par le signal « grossière », permettant d'affiner localement la mesure de la position angulaire ; ce signal de sortie comporte un nombre prédéterminé de P incréments de mesure sur l'intervalle de la mesure ; dans ce cas précis les composantes [Bz ; Btan] seront utilisées pour le calcul de la valeur angulaire.
- et aussi une (ou plusieurs) anomalie(s) magnétique(s) conduisant à des flux atypiques (13) servant d'index « top tour» permettant de comptabiliser le nombre de tours ou d'évènements effectués au-delà d'une première excursion.

Ce signal de sortie comporte un nombre prédéterminé de T incréments de mesure sur l'intervalle de la mesure.

Dans l'exemple illustré par la figure 2, on note pour le profil d'aimantation proposé : N = 2, P = 216 et T = 4.

En traitant chaque signal et en combinant ces signaux, une indication absolue de position angulaire est obtenue pour une détection effectuée sur un ou plusieurs tours mécaniques du capteur.

Pour d'autres motifs d'aimantations, et ou d'autres point de collection des valeurs de champ, d'autres combinaison des composantes de champ $B_{rad}(20)$, $B_{tan}$ (21) et $B_z$ (22) pourront être favorisées pour calculer cette position angulaire absolue.

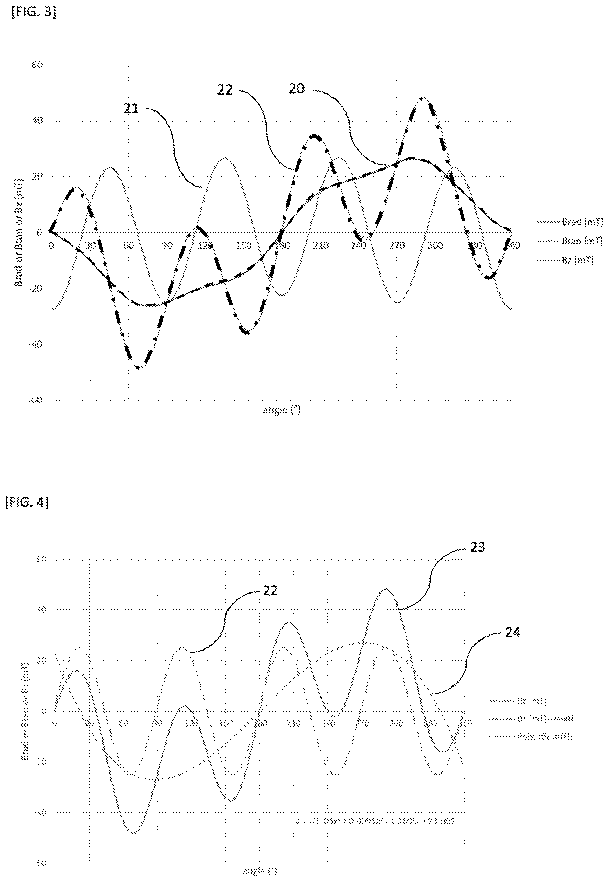

Le principe de calcul de la position sera plus facilement compris au travers de la description d'un exemple avec un profil de champ plus simple, par exemple avec N=2, P =8 et T=0 (figure 3).

La composante Bz (22) pourra être facilement décomposé en une composante (23) porteuse à N incréments (la moyenne du signal enveloppe - voir la courbe (24) Poly(Bz) sur la figure 4) et un signal porté à P incréments obtenu par la soustraction du signal Bz (22) de la moyenne du signal enveloppe (non rapporté sur la figure 4) où la courbe (20) correspond à la variation du signal $B_{rad}(20)$, la courbe (21) correspond à la variation du signal $B_{tan}$ et et la courbe (22) correspond à la variation du signal Bz.

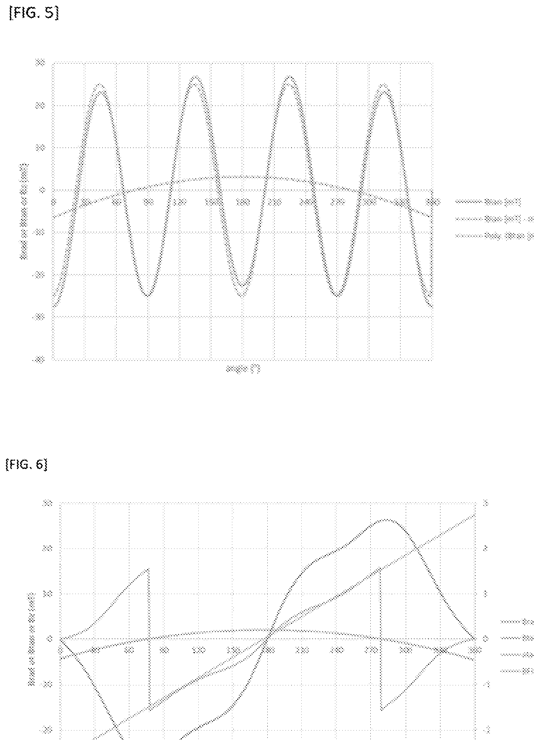

De même la composante Btan (21) fournira une enveloppe à N incréments déphasée d'un quart de période n*p par rapport aux signal équivalent calculés pour la composante $B_z$ (22). Il fournira aussi un signal fin comportant P incréments, déphasés d'un quart de période p (figure 5).

Les moyennes des enveloppes de Bz (noté env(Bz) et de Btan (noté env(Btan) pourront être combinés pour calculer le signal de sortie « grossière », en calculant par exemple l'angle **Téta(N)** (N faisant référence au nombre d'incréments) :

$$\text{Téta(N)} = \text{Atan} ( \text{env(Bz)} / (\text{env(Btan)} * \text{Gain}) )$$

De la même façon, le signal $B_{rad}$ pourrait aussi être directement combiner au signal env(Btan) pour déterminer l'angle **Téta(N)** (N faisant référence au nombre d'incréments) :

$$\text{Téta(N)} = \text{Atan} ( \text{Brad} / (\text{env(Btan)} * \text{Gain}) ) \text{ noté atan sur la figure 6.}$$

La valeur du paramètre « Gain » sera calculé pour ramener le rapport des intensités à une valeur proche de 1, et à limiter la distorsion du signal calculé par rapport au signal idéal (noté BFL (best fit line) sur la figure 6) .

Compte tenu des distorsions des signaux et écart d'indexation, la linéarité de ce signal s'avère tout à fait suffisante pour déterminer une position angulaire dans le tour, avec une non-linéarité importante sur le signal de sortie.

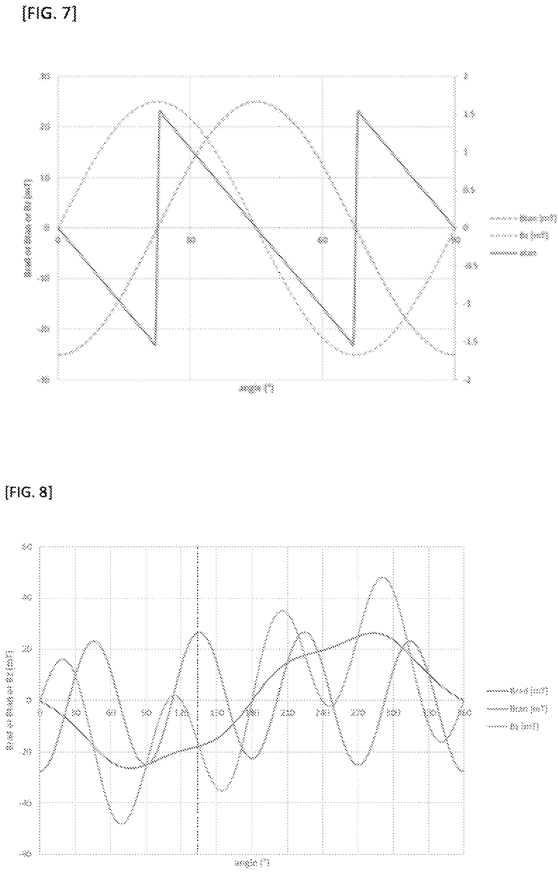

Pour affiner cette mesure de position angulaire, il est possible, de la même manière, combiner les signaux à P incréments issus des composantes Bz et Btan tel qu'illustré par la figure 7.

Avec N=4, on définit un signal linéaire précis sur ¼ de l'excursion mécanique totale (par exemple un tour de 360°).

En combinant les 2 signaux de sortie, on peut identifier :

o avec la sortie « grossière » : le secteur angulaire de l'incrément P au s'effectue la mesure

o avec la sortie « fine » : dans ce secteur de l'incrément P, la valeur angulaire précise.

Dans l'exemple illustré figure 8 (mesure à la valeur indiquée par la ligne pointillée), la sortie « grossière » indique une mesure de l'ordre de 130° (donc le point de mesure se situe sur le 1er incrément N et le 3ième incréments P selon Bz) et la sortie « fine » indique = 320° électrique sur l'incrément P=3, soit 320/P= 40 degrés mécanique dans l'incrément P3, soit au total 45° (1er incrément P) + 45 °(2nd incrément P) + 40° (lu dans le 3ième incrément P) = 130°, à la précision de le NL obtenu sur la sortie « fine » : communément +/-3°électrique sur l'incrément P soit ici +/-3°/P = +/-0.375° mécanique.

◦ la valeur lue sera donc 130° +/-0.375° de façon absolue.

L'ajout d'un index top tour (T=1 ou T=2 ; non représenté), permet d'incrémenter un compteur en détectant simplement le nombre de pic de flux détecté en Bz (par exemple) au-delà d'un certain seuil de référence. La valeur angulaire dans le dernier tour et le nombre de tours complets réalisés est ainsi déterminable.

L'homme de l'art relèvera immédiatement que la précision angulaire du capteur sera d'autant plus importante que le nombre d'incréments P sera important.

Pour une même précision de position issue du traitement sur un incrément N, nous parvenons à augmenter la précision du capteur du ratio :

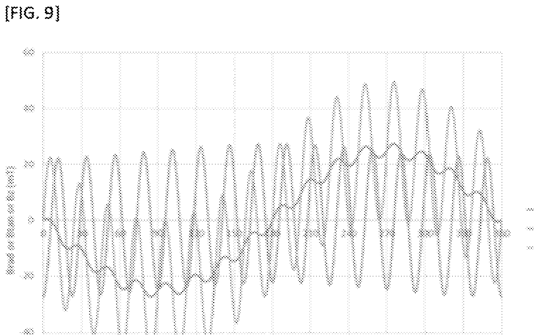

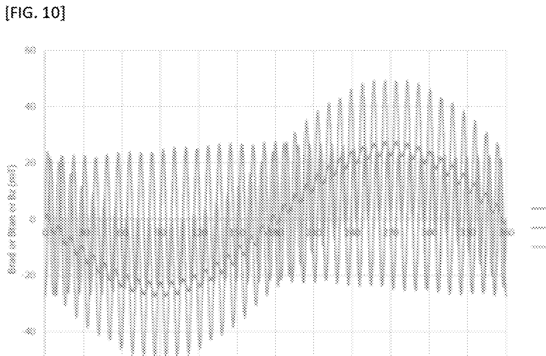

- ∘ P'/ P = 4 pour atteindre +/-0.09° mécanique (figure 9)
- ∘ P''/ P = 10.25 pour atteindre +/-0.036° mécanique (figure 10).

Pour la réalisation pratique de ce capteur nous pouvons sans limitation considérer :

- ∘ une sonde fixe par rapport à un aimant mobile,
- ∘ Une sonde mobile par rapport à un aimant fixe,
- ∘ ou encore un mélange des deux points précédents

**Structure mécanique d'un exemple de capteur à déplacement linéaire ou curviligne selon l'invention**

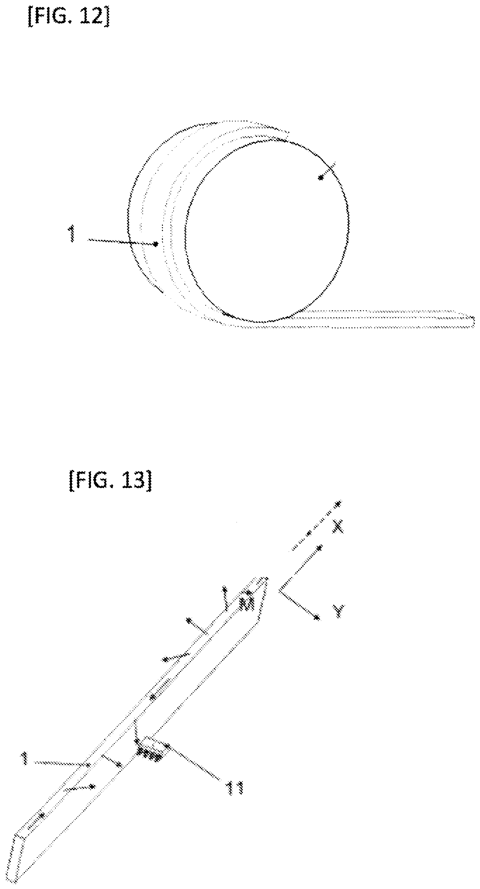

Les figures 12 et 13 représentent des variantes de réalisation d'un capteur à déplacement respectivement curviligne ou linéaire. L'aimant (1) présente une forme plane ou courbe (enroulement sur une partie d'un moyeu cylindrique) avec une aimantation dont l'orientation varie avec des composantes de champ correspondant à une combinaison d'au moins deux contributions quasi-périodiques différentes. Un élément de détection (11) du champs magnétique (ou élément magnéto-sensible) selon au moins deux directions permet de calculer la valeur du déplacement linéaire.

Le principe de détection de l'invention se transpose facilement à la mesure d'un déplacement linéaire ou curviligne. Pour cela il suffit d'ouvrir et de dérouler mentalement (figure 12) une bague ou un disque aimanté (1) pour bien comprendre le principe: le profil d'aimantation varie cette fois continûment selon un déplacement linéaire de la piste magnétique obtenue (figure 13).

Le mode de détection et de calcul de la position reste inchangé. Le valeur du déplacement linéaire est obtenu en indexant ce déplacement à la variation angulaire du champ magnétique réalisé: par exemple, une rotation de 360° du champ magnétique effectuée sur un parcours de 20 mm constituera notre signal porteur.

La superposition d'un motif plus fin périodique (par exemple une rotation de 360° du champ sur un parcours de 5mm répété sur le total de 20mm) constituera notre signal porté permettra d'obtenir comme précédemment décrit une détection plus précise de ce déplacement linéaire. En considérant communément +/-3° de précision sur ces 360° électriques, nous obtenons une précision de +/- 0.041mm sur le déplacement linéaire.

Enfin l'ajout d'une ou plusieurs anomalies magnétiques ponctuels (constituant notre second signal porté) permettra de détecter une ou plusieurs positions particulière sur le déplacement linéaire.

**Revendications**

1. Capteur de position sans contact comportant un aimant permanent (1) générant un champ magnétique et au moins un élément de détection (3, 11) du champs magnétique ou élément magnéto-sensible selon au moins deux directions, l'aimant permanent (1) étant apte à se mouvoir selon une direction de déplacement et présentant une aimantation continûment variable suivant la direction de déplacement, la variation de l'aimantation présentant selon les différentes composantes de champ une forme correspondant à une combinaison d'au moins deux contributions quasi-périodiques différentes, le capteur comportant en outre un calculateur pour combiner les valeurs des composantes de champ et pour déterminer une valeur de la position précise **caractérisé en ce que** ladite aimantation varie avec une fréquence porteuse de période p*n, n réel >0 , constant ou variable sur une excursion, dont la mesure détermine une position grossière, et au moins un signal secondaire porté de période inférieure p pour fournir un signal dont le traitement fourni une mesure fine de la position.

2. Capteur de position selon la revendication 1, **caractérisé en ce que** les signaux porteurs et portés sont indexés entre eux pour créer un déphasage proportionnel à l'excursion effectuée.

3. Capteur de position selon les revendications 2, **caractérisé en ce que** lesdits signaux porteurs et portés sont apériodiques.

4. Capteur de position selon les revendications 2, **caractérisé en ce que** l'aimantation présente au moins une anomalie magnétique pour la détection du tour complet mécanique ou une position donnée dans une excursion.

5. Capteur de position selon la revendication 2, **caractérisé en ce que** ledit aimant permanent est constitué d'au moins un aimant permanent multipolaire, ou d'un assemblage d'aimant multipolaires.

6. Capteur de position selon la revendication 1, **caractérisé en ce que** ledit aimant permanent est tout ou partie du rotor d'un moteur électrique, d'un générateur, d'un actionneur, d'un réducteur, d'un coupleur.

7. Capteur de position selon la revendication 1, **caractérisé en ce que** ledit aimant permanent est constitué par un ensemble de boucles de de courant.

8. Capteur de position selon revendication 1, **caractérisé en ce que** ledit élément magnétosensible est constitué d'au moins une sonde Hall mesurant au moins deux composantes de champ magnétique, ou d'un assemblage quasi-ponctuel d'éléments magnétos-sensibles.

9. Capteur de position selon revendication 1, **caractérisé en ce que** ledit élément magnétosensible est constitué par une sonde Magnétorésistive.

10. Capteur de position selon revendication 1, **caractérisé en ce que** ledit élément magnétosensible est une sonde à courant de Foucault.

11. Capteur de position selon revendication 1, **caractérisé en ce que** ledit élément magnétosensible comprend une pluralité de sondes.

12. Dispositif de mesure comprenant un capteur conforme à l'une quelconque des revendications précédentes, comportant des moyens de calcul, de stockage des valeurs angulaires calculées et/ou de la linéarité du capteur.

13. Dispositif de mesure comprenant un capteur conforme à l'une quelconque des revendications 1 à 11, comportant un mode de fonctionnement -combinaison des composantes de champ-dégradé en cas de défaillance d'une des composantes du champ.

14. Dispositif de mesure selon l'une quelconque des revendications 12 à 13, comportant un mode de fonctionnement -combinaison des composantes de champ-permettant de compenser les perturbations de mesure d'origine externes.

15. Dispositif de mesure selon l'une quelconque des revendications 12 à 14, combinant détection analogique et une détection digitale des composantes de champ magnétique, pour permettre par exemple de gagner en temps de calcul de la position.

16. Application d'un capteur de position selon l'une quelconque des revendications 1 à 11 pour la mesure de valeurs additionnelles sur un système complexe, comprenant une force, un couple, une accélération, un freinage, un déphasage, une vitesse d'ensemble, une direction de déplacement, un nombre de tour, une inertie, un balourd, une vibration, un bruit, un contenu harmonique, une température, une pression, un courant électrique, une tension électrique.

**Patentansprüche**

1. Berührungsloser Positionssensor, umfassend einen ein Magnetfeld erzeugenden Permanentmagneten (1) und mindestens ein Magnetfelddetektionselement (3, 11) oder gegenüber Magnetfeldern empfindliches Element in mindestens zwei Richtungen, wobei der Permanentmagnet (1) in einer Bewegungsrichtung beweglich ist und eine sich in Bewegungsrichtung kontinuierlich ändernde Magnetisierung aufweist, wobei die Änderung der Magnetisierung entsprechend den unterschiedlichen Feldkomponenten eine Form aufweist, die einer Kombination von mindestens zwei verschiedenen quasiperiodischen Beiträgen entspricht, wobei der Sensor ferner eine Recheneinrichtung zum Kombinieren der Werte der Feldkomponenten und zum Bestimmen eines Werts der genauen Position umfasst, **dadurch gekennzeichnet, Blass** sich die Magnetisierung mit einer Trägerfrequenz der Periode p*n ändert, wobei ein reelles n >0 und auf einer Wegstrecke konstant oder variabel ist, durch deren Messung eine Position grob bestimmt wird, und mit mindestens einem übertragenen Sekundärsignal mit einer kürzeren Periode p ändert, sodass ein Signal bereitgestellt wird, dessen Verarbeitung eine Feinmessung der Position ermöglicht.

2. Positionssensor nach Anspruch 1, **dadurch gekennzeichnet, dass** das Träger- und das übertragene Signal derart miteinander gekoppelt sind, dass eine zur zurückgelegten Wegstrecke proportionale Phasenverschiebung erzeugt wird.

3. Positionssensor nach Anspruch 2, **dadurch gekennzeichnet, dass** das Träger- und das übertragene Signal aperiodisch sind.

4. Positionssensor nach Anspruch 2, **dadurch gekennzeichnet, dass** die Magnetisierung mindestens eine magnetische Anomalie zum Detektieren der gesamten mechanischen Umdrehung oder einer gegebenen Position auf einer Wegstrecke aufweist.

5. Positionssensor nach Anspruch 2, **dadurch gekennzeichnet, dass** der Permanentmagnet aus mindestens einem multipolaren Permanentmagneten oder einer multipolaren Magnetanordnung besteht.

6. Positionssensor nach Anspruch 1, **dadurch gekennzeichnet, dass** der Permanentmagnet der gesamte oder ein Teil des Rotors eines Elektromotors, eines Generators, eines Aktuators, eines Getriebes oder einer Kupplung ist.

7. Positionssensor nach Anspruch 1, **dadurch gekennzeichnet, dass** der Permanentmagnet aus einer Zusammenstellung von Stromschleifen besteht.

8. Positionssensor nach Anspruch 1, **dadurch gekennzeichnet, dass** das gegenüber Magnetfeldern empfindliche Element aus mindestens einer mindestens zwei Magnetfeldkomponenten messenden Hall-Sonde oder einer Quasi-Punkt-Anordnung aus gegenüber Magnetfeldern empfindlichen Elementen besteht.

9. Positionssensor nach Anspruch 1, **dadurch gekennzeichnet, dass** das gegenüber Magnetfeldern empfindliche Element aus einer magnetoresistiven Sonde besteht.

10. Positionssensor nach Anspruch 1, **dadurch gekennzeichnet, dass** das gegenüber Magnetfeldern empfindliche Element eine Wirbelstromsonde ist.

11. Positionssensor nach Anspruch 1, **dadurch gekennzeichnet, dass** das gegenüber Magnetfeldern empfindliche Element eine Vielzahl von Sonden umfasst.

12. Messvorrichtung, umfassend einen Sensor nach einem der vorstehenden Ansprüche, mit Mitteln zum Berechnen und Speichern berechneter Winkelwerte und/oder der Linearität des Sensors.

13. Messvorrichtung, umfassend einen Sensor nach einem der Ansprüche 1 bis 11, mit einen Betriebsmodus zum Kombinieren von verminderten Feldkomponenten bei Ausfall einer der Feldkomponenten.

14. Messvorrichtung nach einem der Ansprüche 12 bis 13, umfassend einen Betriebsmodus zum Kombinieren von Feldkomponenten, mit dem Messstörungen externen Ursprungs kompensiert werden können.

15. Messvorrichtung nach einem der Ansprüche 12 bis 14, die das analoge Detektieren und das digitale Detektieren von Magnetfeldkomponenten kombiniert, sodass beispielsweise eine Zeitersparnis bei der Positionsberechnung erreicht werden kann.

16. Verwenden eines Positionssensors nach einem der Ansprüche 1 bis 11 zum Messen zusätzlicher Werte bei einem komplexen System, umfassend eine Kraft, ein Drehmoment, eine Beschleunigung, ein Bremsen, eine Phasenverschiebung, eine Gesamtgeschwindigkeit, eine Bewegungsrichtung, eine Anzahl von Umdrehungen, eine Trägheit, eine Unwucht, eine Vibration, ein Geräusch, einen Oberschwingungsgehalt, eine Temperatur, einen Druck, einen elektrischen Strom, eine elektrische Spannung.

**Claims**

1. Contactless position sensor comprising a permanent magnet (1) generating a magnetic field and at least one magnetic field detection element (3, 11) or magneto-sensitive element in at least two directions, the permanent magnet (1) being able to move in a movement direction and having a continuously variable magnetization along the movement direction, the variation of the magnetization having, according to the different field components, a shape corresponding to a combination of at least two different quasi-periodic contributions, the sensor further comprising a computer for combining the values of the field components and for determining a value of the precise position, **characterized in that** said magnetization varies with a carrier frequency of period p*n, n being a real number >0 and constant or variable over an excursion, the measurement of which determines a rough position, and at least one carried secondary signal having a lower period p to provide a signal whose processing provides a precise measurement of the position.

2. Position sensor according to claim 1, **characterized in that** the carrier and carried signals are indexed to each other to create a phase shift proportional to the excursion performed.

3. Position sensor according to claim 2, **characterized in that** said carrier and carried signals are aperiodic.

4. Position sensor according to claim 2, **characterized in that** the magnetization has at least one magnetic anomaly for the detection of the mechanical complete revolution or a given position in an excursion.

5. Position sensor according to claim 2, **characterized in that** said permanent magnet consists of at least one multipole permanent magnet, or a multipole magnet assembly.

6. Position sensor according to claim 1, **characterized in that** said permanent magnet is all or part of the rotor of an electric motor, a generator, an actuator, a reducer, or a coupler.

7. Position sensor according to claim 1, **characterized in that** said permanent magnet consists of a set of current loops.

8. Position sensor according to claim 1, **characterized in that** said magneto-sensitive element consists of at least one Hall probe measuring at least two magnetic field components, or a quasi-point assembly of magneto-sensitive elements.

9. Position sensor according to claim 1, **characterized in that** said magneto-sensitive element consists of a magneto-resistive probe.

10. Position sensor according to claim 1, **characterized in that** said magneto-sensitive element is an eddy current probe.

11. Position sensor according to claim 1, **characterized in that** said magneto-sensitive element comprises a plurality of probes.

12. Measurement device comprising a sensor according to any of the preceding claims, having means for calculating and storing calculated angular values and/or the sensor linearity.

13. Measurement device comprising a sensor according to any of claims 1 to 11, having a degraded operating mode (combination of the field components) in the event of failure of one of the field components.

14. Measurement device according to any of claims 12 to 13, having an operating mode (combination of the field components) making it possible to compensate for the external measurement disturbances.

15. Measurement device according to any of claims 12 to 14, combining analog detection and digital detection of the magnetic field components, for example to save time calculating the position.

16. Application of a position sensor according to any of claims 1 to 11 for measuring additional values on a complex system, including force, torque, acceleration, braking, phase shift, overall speed, movement direction, number of revolutions, inertia, imbalance, vibration, noise, harmonic content, temperature, pressure, electrical current, and electrical voltage.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

[FIG. 13]

## RÉFÉRENCES CITÉES DANS LA DESCRIPTION

**Documents brevets cités dans la description**

- FR 2965347
- FR 2923903
- FR 2919385
- FR 2898189
- EP 2711663 A